# EUROPEAN PATENT APPLICATION

(11) **EP 4 819 205 A1**
(43) Date of publication of application: **07.10.2026**
(21) Application number: 25167508.8
(22) Date of filing: 31.03.2025
(51) Int. Cl.: H01L 23/473, H01L 25/07, H02M 7/00, H05K 7/20

(54) **POWER MODULE AND METHOD FOR MANUFACTURING A POWER MODULE**

(71) Applicant: Hitachi Energy Ltd, 8050 Zürich (CH)
(72) Inventor: Santolaria, Luis, 4600 Olten (CH); Truessel, Dominik, 5620 Bremgarten (CH); Maleki, Milad, 5417 Untersiggenthal (CH)
(74) Representative: Epping - Hermann - Fischer

(57) **Abstract**

A power module (1) comprising several switching units (2a, 2b, 2c) and a cooler (3) for liquid cooling, wherein the switching units (2a, 2b, 2c) are mounted on the cooler (3), wherein the cooler (3) comprises an inlet (6) and an outlet (8) for a cooling liquid, the inlet (6) and the outlet (8) being located on a top side (4) and/or a bottom side (5) of the cooler (3), wherein in a view on the top side (4) of the cooler (3) an overlap (Aa, Ab, Ac) of one of the switching units (2a, 2b, 2c) with the inlet (6), the outlet (8), a blind channel section (19) of the cooling channel (7) and/or an area of the cooler (3) where the cooling channel (7) is not present is larger than for another one of the switching units (2a, 2b, 2c).

## Description

The present disclosure relates to a power module comprising several switching units mounted on a cooler. The cooler comprises a channel in which a coolant flows. The coolant may be liquid or gas. The power module may be an inverter for an automotive application, for example.

WO2023/179873 A1 discloses a power device comprising several power semiconductor modules mounted on a top and/or bottom side of a cooler. The inlet and outlet for the cooler is located on the bottom side of the cooler. The power semiconductor modules are mounted symmetrically between the inlet and the outlet in a view on the top side of the cooler.

CN 110678043 A discloses a power device comprising a liquid-cooled radiator in which an inlet and an outlet for the cooler are located at side faces of the cooler. The heights of heat dissipation fins increase stepwise in different flow passage areas. Furthermore, parallel heat dissipating flow channels are present to improve heat-dissipation.

Embodiments of the disclosure relate to an improved power module comprising a cooler.

A power module comprises several switching units and a cooler for liquid cooling, wherein the switching units are mounted on the cooler. The cooler comprises an inlet and an outlet for a cooling liquid, wherein the inlet and the outlet are located on a top and/or bottom side of the cooler. Both the inlet and the outlet may be located on the bottom side or the top side. It is also possible that the one of inlet and outlet is located on the bottom side and the other one on the top side, or vice versa.

The power module may be suitable for use in an inverter for automotive applications, for example. The three switching units may comprise identical designs. Each of the three switching units may comprise two switching devices forming the high side and the low side of a half bridge. The switching units may be phase-leg switching units. The power module may comprise three switching units representing the three phases of the power module. The switching devices may be power semiconductor chips.

The switching units may comprise an inlet-side switching unit and an outlet-side switching unit, wherein in a view on a top side of the cooler the inlet-side switching unit is closest to the inlet and the outlet-side switching unit is closest to the outlet. The inlet-side switching unit may be closest to the inlet in relation to all other switching units. In case the power module comprises switching units of different layouts and/or functionality, the inlet-side switching unit may be closest to the inlet in relation to all other switching units of the same layout and functionality of the power module.

As an example, when the switching units are phase-leg switching units, the inlet-side switching unit may be closest to the inlet in relation to all other phase-leg switching units. Correspondingly, the outlet-side switching unit is closest to the outlet in relation to all other switching units, in particular, in relation to all other switching units with the same layout and functionality. The distance of the inlet-side switching unit to the inlet and of the outlet-side switching unit to the outlet can be determined by distances of center points of the switching units and center points of the inlet or outlet, for example.

On a top view on the cooler, the cooler may have first edges opposite to each other and second edges opposite to each other. The cooler may have a rectangular shape. The first edges may be long edges and the second edges may be short edges. The first edges may define an x-direction and the second edges may define an y-direction when seen on top of the cooler. It is also possible that the cooler does not have a rectangular shape. Also in this case, the x-direction and y-direction may be defined by first and second edges. It is also possible to define an x-direction by a connection line of the center points of the switching units, for example. It may be also possible to define the x-direction by a connection line between central points of inlet and outlet. The y-direction is then a direction perpendicular to the x-direction and parallel to a main surface of the cooler.

The cooler comprises a cooling channel in which the coolant flows from the inlet to the outlet. In a top view on the cooler, the cooling channel may have a rectangular geometry. In a top view on the cooler, the cooling channel may have edges parallel to the first and second edges It is also possible that the cooling channel has a different geometry, e.g. narrowed parts between inlet and outlet. Such narrowed parts may provide space for screw holes for mounting the units, for example. It is also possible that the cooling channel has several windings. It is also possible that the cooling channel has different extensions in a direction perpendicular to the main flow direction when seen in a view on the top of the cooler. Accordingly, the cooling channel may have different widths at different locations. It is also possible that the cooling channel has different thicknesses, i.e., different extensions in a z-direction, perpendicular to the x-y plane.

The switching units may be arranged in a row. The switching units may be arranged in a row along the x-direction. The switching units may be arranged in a row along a main flow direction of the coolant in the cooling channel from the inlet towards the outlet. Depending on the geometry of the cooling channel, the x-direction may be the main flow-direction. It is also possible that the switching units have different positions in y-direction. Accordingly, the switching units can be arranged in a straight row or in a non-straight row, for example.

A connection line between the inlet and the outlet may extend along the x-direction in a view on the top side of the cooler. It is also possible that the inlet and/or the outlet have different positions in y-direction. In this case, the connection line may deviate from the x-direction.

As an example, when seen in a view on the top of the cooler, an overlap of one of the switching units with the inlet, the outlet, a blind channel section of the cooling channel and/or an area of the cooler where the cooling channel is not present may be larger than for another one of the switching units. As an example, the overlap may be larger for the inlet-side switching unit than for the outlet-side switching unit.

An overlap of the inlet-side switching unit with the inlet and/or with a blind channel section and/or with an area of the cooler where the cooling channel is not present may be larger than an overlap of the outlet-side switching unit with the outlet and/or with a blind channel section of the cooling channel and/or with an area of the cooler where the cooling channel is not present. As an example, the overlap for the outlet-side switching unit may be zero while the overlap for the inlet-side switching unit is larger than zero.

As the coolant heats up in the cooling channel on its way from the inlet towards the outlet due to heat dissipation of the switching units, the cooling efficiency of the coolant decreases along the channel, which leads to an increase of the temperature, e.g. a junction temperature, of the switching units with increasing distance from the inlet. Thus, the temperature of the coolant at the location of the inlet-side switching unit is smaller than at the location of the outlet-side switching unit. Different junction temperatures will result in an inhomogeneous switching behaviour between the switching units.

The temperature difference of the coolant at the locations of the inlet-side switching unit and the outlet-side switching unit and, thereby, the decreased cooling efficiency of the coolant, can be at least partially compensated by positioning the inlet-side switching unit such that its overlap with a section of the cooling channel with directed coolant flow in the main flow direction is smaller than for the other switching units, particularly the outlet-side switching unit.

The coolant flow along the main flow direction is diminished in the vicinity of the inlet due to stagnation of the coolant when the coolant enters the cooler from the top or bottom side. The coolant flow is particularly diminished in comparison to the coolant flow in a central part of the cooling channel between inlet and outlet where the coolant flow is strongly directed from the inlet to the outlet. It is also possible that a blind channel is present, e.g. between the inlet and the adjacent edge, with little or no coolant flow in the main flow direction. Thus, a larger overlap with the inlet and/or the blind channel leads to a reduced cooling of the inlet-side switching unit and, thus, to an increased temperature. Specifically, an overlap with such areas leads to a reduced cooling when compared to a location where the switching unit overlaps entirely with an area of strong directed coolant flow.

The amount of directed flow of coolant in the main flow direction from inlet to outlet corresponds to flow rate and results in a certain pressure drop in the coolant. When the coolant stagnates, e.g. above the inlet and a blind channel section, the flow rate is zero or very low and the pressure in the coolant remains constant or only drops slightly. In particular, the flow rate and pressure drop is much less than in a central section of the cooling channel where the directed flow is large.

As an example, a distance of the inlet-side switching unit from the inlet in x-direction may be smaller than a distance of the outlet-side switching unit from the outlet in x-direction when seen in a view on a top side of the cooler.

The switching units may have plain bottom sides mounted on the cooler. It is also possible that the switching units have pin-fins at their bottom sides, wherein the pin-fins extend into the cooling channel. In this case, the switching units are mounted on opening of the cooler housing and get in contact with the coolant.

The inlet-side switching unit may be located on a top side of the cooler. It is also possible that some of the switching units are located on a bottom side of the cooler. As an example, the inlet-side switching unit and the outlet-side switching unit are located on the top side of the cooler while a further switching unit is located on the bottom side of the cooler.

The switching units may be provided as separate sub-modules. In this case, each of the switching units comprises a separate package body and is separately mounted on the cooler. It is also possible that the switching units are provided in a single sub-module. In this case, the switching units are packaged within a common package body and then mounted on the cooler. A switching unit in a single sub-module may be defined by the active areas of the semiconductor chips. A distance of a switching unit in a single sub-module from the inlet or the outlet may be defined as the distance of a center point of the active areas of the chips in a half-bridge design, e.g. as a geometrically weighted center point, particularly in x-direction.

The inlet-side switching unit may overlap with the inlet in a view on the top side of the cooler. The outlet-side switching unit may not overlap with the outlet or may have a smaller overlap with the outlet.

Generally, "overlap" may mean a partial overlap or a complete overlap. An overlap may mean that, when seen in a view on top of the cooler, at least an area within the perimeter of a package body of the inlet-side switching unit overlaps with the inlet. When providing the switching units in a single sub-module, at least an area within the perimeter of the package body of the single sub-module may overlap with the inlet. The package body may not overlap with the outlet or may have less overlap with the outlet.

The active areas of one of the switching units may overlap to a larger extent with the inlet, the outlet, a blind channel section of the cooling channel and/or an area of the cooler than the active areas of at least another one of the switching units. As an example, the active areas of the inlet-side switching unit overlap with the inlet and the active areas of the outlet-side switching unit does not overlap or overlaps to a smaller extent with the outlet. An active area of a switching unit includes the areas of the chips in a switching unit and the space between the areas of the chips. It is also possible that the center point of two chips in a half-bridge overlaps with the inlet.

In case of an overlap of the inlet-side switching unit with the inlet, the inlet-side switching unit is positioned in an area with less directed coolant flow along the main flow direction when compared to a central section of the flow channel between the inlet and the outlet. Accordingly, the cooling efficiency decreases with an increasing amount of overlap. The amount of directed coolant flow is also small or zero at a location of the flow channel which is not located between inlet and outlet but, e.g., located in a blind channel section between the inlet and the adjacent edge. By positioning the inlet-side switching unit at such a location, the temperature of the inlet-side switching unit can be increased when compared to positioning the switching unit at a central section of the flow channel between inlet and outlet.

The inlet and outlet may be located at the same distance to the respectively adjacent second edges of the cooler. In this case, the arrangement can be symmetric. It is also possible that the inlet is located at a larger distance from the adjacent second edge than the outlet. In the latter case, the inlet-side switching unit and the outlet-side switching unit may be located at the same distance to the respectively adjacent second edges of the cooler. Also in this case, the distance of the inlet-side switching unit from the inlet can be smaller than the distance of the outlet-side switching unit from the outlet.

The switching units may comprise a further switching unit located between the inlet-side switching unit and the outlet-side switching unit. The switching units may be located at equal distances to each other, i.e., the distance between the inlet-side switching unit and the further switching unit may be the same as the distance between the outlet-side switching unit and the further switching unit. The distance can be a distance in x-direction, for example or a distance in the x-y plane, for example. It is also possible that the further switching unit has a larger distance from the inlet-side switching unit than from the outlet-side switching unit.

The switching units may be located at different positions in respect to y-direction. By such a positioning, the overlap with an area of the cooling channel with directed coolant flow along the main flow direction can be adjusted as well. As an example, by shifting the position of one or more of the switching units, the switching unit may only partly overlap with the cooling channel. Furthermore, at least one of the switching units may be positioned such that it overlaps less with the cooling channel than the other switching units. As an example, a further switching unit positioned between the inlet-side switching unit and the outlet-side switching unit is shifted in y-direction to decrease the cooling efficiency and to achieve a further temperature homogenization.

The switching units may be positioned such that, in operation of the power module, a junction temperature of the inlet-side switching unit is higher than a junction temperature of at least another one of the switching units. Thereby, the overall spread of the junction temperatures of the switching units can be decreased. In an optimal situation, all three or more switching units would have the same temperature.

The power module may comprise a further component, wherein in a view on the top side of the cooler, the further component overlaps with the outlet. It is also possible that the further component is located above a blind channel section next to the outlet. Thereby, the free space is optimally used, and the extension of the power module can be minimized.

In a specific embodiment, a power module comprises several switching units and a cooler for liquid cooling, wherein the switching units are mounted on the cooler. The cooler comprises an inlet and an outlet for a cooling liquid, wherein the inlet and the outlet are located on a top and/or bottom side of the cooler. In a view on the top side of the cooler an overlap of one of the switching units with the inlet, the outlet, a blind channel section of the cooling channel and/or an area of the cooler where the cooling channel is not present is larger than for another one of the switching units. The specific embodiment may comprise any further functional and structural features as described in the foregoing.

In a further specific embodiment, a power module comprises several switching units and a cooler for liquid cooling, wherein the switching units are mounted on the cooler. The cooler comprises an inlet and an outlet for a cooling liquid, wherein the inlet and the outlet are located on a top and/or bottom side of the cooler. The power module is configured such that in a view on the top side of the cooler at least one of the switching units is located at a position where the amount of directed coolant flow, the flow rate and/or the pressure drop in the cooling channel is smaller than at a position of at least another one of the switching units. The specific embodiment may comprise any further functional and structural features as described in the foregoing.

According to a further aspect of the invention, a method for manufacturing a power module arrangement comprises providing several switching units and a cooler. The cooler comprises an inlet and an outlet located at a bottom side of the cooler. The cooler and switching units can be provided in real life or in a computer simulation. The resulting power module may be the power module described in the foregoing.

The method comprises the further step of determining a cooling efficiency of the cooler at different locations of the cooler. This step can be done in real life or by simulation. As examples, the amount of directed coolant flow along a main flow direction, a flow rate and/or a pressure drop at different locations of the cooler during operation is determined. In a further step, the switching units are mounted such on the cooler that the amount of directed coolant flow, the flow rate and/or the pressure drop at the position of one of the switching units is smaller than at the position of at least another one of the switching units. The values can be determined as an average over an area of the switching unit, e.g. the area within the perimeter or an area of the active region, for example. The values may also be determined at the center position of the switching unit. It is also possible that the one of the switching units is positioned such that it at least partly does not overlap with the cooling channel.

As an example, the lower temperature of the coolant at the location of the inlet-side switching unit can be at least partially compensated by a reduced overlap with directed coolant flow. As an example, a junction temperature of the inlet-side switching unit may be higher than a junction temperature of another one of the switching units. The power module arrangement obtained by the method may be the power module arrangement described in the foregoing.

The present disclosure comprises several aspects and embodiments. Every feature described with respect to one of the aspects and embodiments is also disclosed herein with respect to the other aspects and embodiments, even if the respective feature is not explicitly mentioned in this context.

Further features, refinements and expediencies become apparent from the following description of the exemplary embodiments in connection with the figures. In the figures, elements of the same structure and/or functionality may be referenced by the same reference signs. It is to be understood that the embodiments shown in the figures are illustrative representations and are not necessarily drawn to scale.
- Figure 1A: shows an embodiment of a power module in a schematic longitudinal-sectional view,
- Figure 1B: shows the power module of Fig. 1A in a view on the top,
- Figure 1C: shows the power module of Fig. 1A in a view on the top with an illustration of an amount of overlap,
- Figure 2A: shows a further embodiment of a power module in a schematic longitudinal-sectional view,
- Figure 2B: shows the power module of Fig. 2A in a view on the top,
- Figure 3: shows a further embodiment of a power module in a view on the top,
- Figure 4A: shows a further embodiment of a power module in a view on the top,
- Figure 4B: shows the power module of Fig. 4A in a view on the top with an illustration of an amount of overlap,
- Figure 5: shows a further embodiment of a power module in a view on the top,
- Figure 6A: shows a further embodiment of a power module in a view on the top,
- Figure 6B: shows the power module of Fig. 6A in a view on the top with an illustration of an amount of overlap,
- Figure 7: shows a further embodiment of a power module in a longitudinal sectional view,
- Figure 8: shows a further embodiment of a power module in a longitudinal sectional view,
- Figure 9: shows further embodiments of a power module in a view on the top,
- Figure 10: shows a further embodiment of a power module in a view on the top,
- Figure 11: shows steps in an embodiment of a method for manufacturing a power module in a schematic diagram,
- Figure 12A: shows a comparative example of a power module in a schematic longitudinal-sectional view,
- Figure 12B: shows the power module arrangement of Fig. 12A in a view on the top.

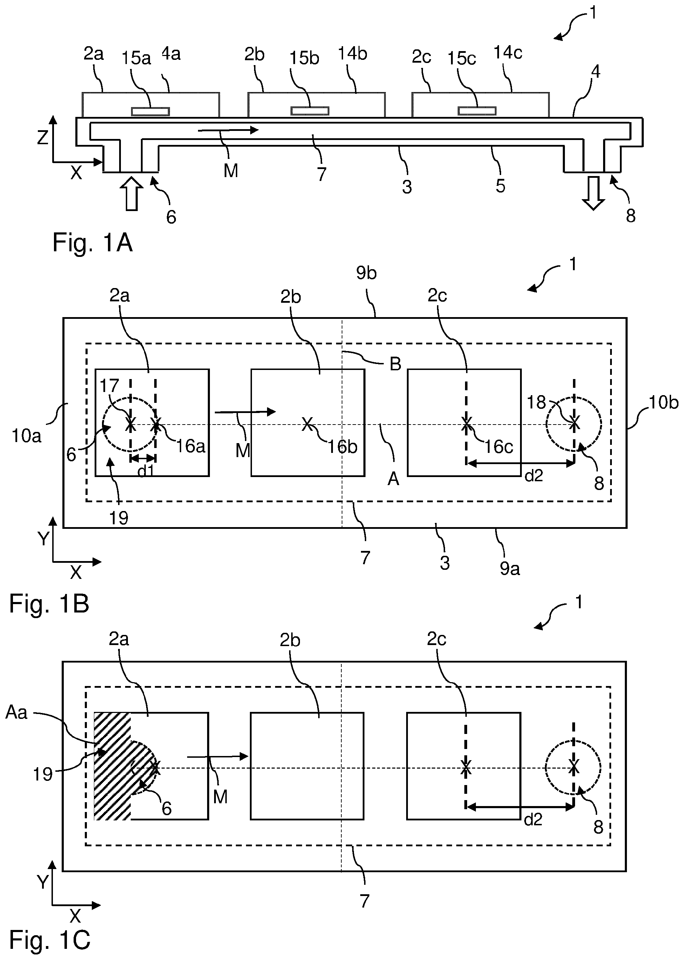

Fig. 1A shows an embodiment of a power module 1 in a longitudinal sectional view. Fig. 1B shows the power module 1 in a view on a top.

The power module 1 comprises an arrangement of switching units 2a, 2b, 2c located on a top side 4 of a cooler 3. It is also possible that one or more of the switching units 2a, 2b, 2c are located on a bottom side 5 of the cooler 3.

The cooler 3 comprises an inlet 6 through which a liquid coolant enters a cooling channel 7 in the cooler 3 and an outlet 8 through which the coolant leaves the cooling channel 7. The inlet 6 and the outlet 8 are located at the bottom side 5 of the cooler 3. It is also possible that the inlet 6 and the outlet 8 are located on the top side 4 or that the inlet 6 is located on the top side 4 and the outlet 8 is located on the bottom side 5, or vice versa.

The cooling channel 7 has a rectangular shape when seen on the top of the cooler 3. The inlet 6 and the outlet 8 are located inside the perimeter of the cooling channel 7, i.e. completely overlap with the cooling channel 7. Other geometries of the cooling channel 7 are possible. As an example, the inlet 6 and/or outlet 8 can be outside the perimeter of the cooling channel 7. It is also possible that the cooling channel 7 has a different geometry. It is also possible that the cooling channel 7 has a different geometry, e.g. narrowed parts between inlet and outlet. Such narrowed parts may provide space for screw holes for mounting the units, for example. It is also possible that the cooling channel has several windings.

The power module 1 is suitable for use in an inverter for automotive applications, for example. The three switching units 2a, 2b, 2c are provided as separate sub-modules 14a, 14b, 14c mounted on the cooler 3. The sub-modules 14a, 14b, 14c may have identical designs. Each sub-module may comprise two switching devices 15a, 15b, 15c forming the high-side and the low-side of a half-bridge, wherein each sub-module may represent one phase of the power module 1. One of the switching devices 15a, 15b, 15c of each switching unit 2a, 2b, 2c is shown in Fig. 1A while the other one may be located behind the respective switching devices 15a, 15b, 15c. Further components such as a substrate backside or a baseplate may be present but are not separately shown in the Figures.

The switching devices 15a, 15b, 15c may be power semiconductor chips such as an IGBT, a diode, a MOSFET, a thyristor, a JFET, a HEMT, for example. The power module 1 may comprise exactly three switching units 2a, 2b, 2c, each providing a half-bridge. Accordingly, the switching units 15a, 15b, 15c may be phase-leg switching units.

The switching units 2a, 2b, 2c may be molded packages. It is also possible that the switching units 2a, 2b, 2c comprise gel-filled or resin-filled housings. The switching units 2a, 2b, 2c may have a baseplate or an exposed substrate backside.

In the depicted embodiment, the switching units 2a, 2b, 2c have a flat bottom side. The cooler 3 is a closed cooler with a flat top surface on which the switching units 2a, 2b, 2c are mounted. The switching units 2a, 2b, 2c can be mounted on the cooler 3 by screwing, soldering, sintering, clamping, gluing or any other suitable joining method. The joining material may also be used as thermal interface material. It is also possible that a separate thermal interface material like thermal grease is used, e.g. in the case of screwing or clamping.

It is also possible that the switching units 2a, 2b, 2c have pin-fin bottom sides. The switching units 2a, 2b, 2c may have a baseplate with cooling fins. It is also possible that the cooling fins are provided on a substrate backside on which the semiconductor dies are formed. In this case, the channel 7 may have an opening at its top side, wherein the switching units 2a, 2b, 2c are mounted on the opening, with the pin-fins extending into the channel 7. Thereby, the pin-fins get in contact with the cooling liquid. It is also possible that one or more of the switching units 2a, 2b, 2c are mounted on the bottom side, wherein also the opening is arranged in the bottom side. In this case, the switching units 2a, 2b, 2c may be fixed to the cooler 3 by screws or screwed clamps or any other suitable method.

The cooler 3 may be made of copper or aluminum, or corresponding alloys, but also other materials are possible like plastic materials. Combinations of two or more materials may be possible as well, e.g. of copper and aluminum or of any metal and plastic.

The switching units 2a, 2b, 2c comprise an inlet-side switching unit 2a, which is closest to the inlet 6 and an outlet-side switching unit 2c, which is closest to the outlet 8 when seen on the top side 5 of the cooler 3 (see Fig. 1B). In particular, the inlet-side switching unit 2a may be closest to the inlet 6 and the outlet-side switching unit 2c may be closest to the outlet 8 in regard of all phase-leg switching units. There may be further electronic devices, which may be positioned closer to the inlet or the outlet.

During operation, the coolant enters the channel 7 from the inlet 6 and cools the switching units 2a, 2b, 2c sequentially on its way towards the outlet 8. The coolant heats up on its way towards the outlet 8, leading to a decreased cooling efficiency of the coolant along the channel 7 in the direction of the outlet 8. The temperature of the coolant is lowest at the position of the inlet-side switching unit 2a and highest at the position of the outlet-side switching unit 2c. Accordingly, the cooling efficiency of the coolant is different at the different locations and, with no further measures, this may lead to temperature differences and an inhomogeneous switching behavior of the switching units 2a, 2b, 2c.

To compensate for the difference of cooling efficiency of the coolant due to the difference in temperature of the coolant along the cooling channel 7, the switching units 2a, 2b, 2c are positioned such that the amount of directed coolant flow along a main flow direction M differs at the different locations of the switching units 2a, 2b, 2c. This can be achieved by positioning one or more of the switching units 2a, 2b, 2c such that the switching unit 2a, 2b, 2c partly overlaps with a part of the cooling channel 7 where the amount of coolant flow along the main flow direction M is reduced, e.g. above the inlet 6 or in a niche of the cooling channel 7. It is also possible to position one or more of the switching units 2a, 2b, 2c such that they only partly overlap with the cooling channel 7.

In the shown embodiment, the main flow direction M is in x-direction, which is a longitudinal direction when seen in a view on the top side 5 the cooler 3. The switching units 2a, 2b, 2c are positioned one after the other in x-direction. An y-direction is a direction perpendicular to the x-direction when seen in a view on the top side 5 of the cooler 3. The x-direction may be defined by first lateral edges 9a, 9b and the y-direction may be defined by second lateral edges 10a, 10b of the cooler 3. The first lateral edges 9a, 9b may be long edges and the second lateral edge 10a, 10b may be short edges of the cooler 3. The cooling channel 7 has a constant width, i.e., a constant extension in a direction perpendicular to a main flow direction M in a view on the top side 4 of the cooler 3.

The coolant flow along the main flow direction M is less in the vicinity of the inlet 6 due to stagnation of the coolant when the coolant enters the cooler 3 from the bottom side 5. The inlet-side switching unit 2a overlaps with the inlet 6 and further overlaps with a blind channel section 19 of the cooling channel 7. In both areas, the directed coolant flow in the main flow direction is reduced. A blind channel section 19 may be defined as a section of the cooling channel 7 which is located not in the main flow direction M but, for example, in the opposite direction of the main flow direction when seen from a center point 17 of the inlet 6. In this section, the coolant flow is significantly reduced or even not present. It is also possible to define the blind channel section 19 in relation to a point at the perimeter of the inlet 6.

Fig. 1C illustrates the area of overlap Aa of the inlet-side switching unit 2a with the inlet 6 and a blind channel section 19 of the cooling channel 7. In comparison, the outlet-side switching unit 2c and the further switching unit 2b do not have an overlap with the inlet 6, the outlet 8 or a blind channel section.

The inlet-side switching unit 2a is positioned such that its distance d1 from the inlet 6 is smaller than the distance d2 of the outlet-side switching unit 2c from the outlet 8. The distance of a switching unit 2a, 2b, 2c from the inlet 6 and the outlet 8, respectively, can be defined by a distance between a center point 16a, 16, 16c of the respective switching unit 2a, 2b, 2c and a center point 17 of the inlet 6 and a center point 19 of the outlet 8, respectively. In case the switching units 2a, 2b, 2c have the same position in y-direction, the distance may be the distance in x-y direction. In case the y-positions differ, it is possible to define the distance also in x-y direction or only in x-direction. The center points are marked by crosses in Fig. 1A. In principle, it is also possible that the center point of the inlet-side switching unit 2a is located between the center point of the inlet 6 and the adjacent second edge 10a. In this case, the cooling efficiency for the inlet-side switching unit 2a may be further reduced because of being located on the blind channel section 19.

Due to the smaller distance d1 of the inlet-side switching unit 2a from the inlet 6 than the distance d2 of the outlet-side switching unit 2c from the outlet 8, particularly in case of an overlap with the inlet 6 and/or a blind channel section 19, the amount of directed coolant flow in the main flow direction below the inlet-side switching unit 2a can be less than the amount of directed coolant flow in the main flow direction below the outlet-side switching unit 2c. With a larger distance from the inlet 6 and the outlet 8 in the main flow direction M along the cooling channel 7, the amount of directed coolant flow in the main flow direction M increases.

In the shown embodiment, the inlet-side switching unit 2a overlaps in view on a top side 5 of the cooler 3 with the inlet 6. It is possible that the inlet-side switching unit 2a entirely overlaps with the inlet 6 - as shown - or the inlet-side switching unit 2a only partially overlaps with the inlet 6. In particular, the active area, i.e. the semiconductor chips may overlap with the inlet 6. An active area of a switching unit 2a, 2b, 2c includes the areas of the chips in the switching unit 2a, 2b, 2c and may also include the space between the areas of the chips forming a half-bridge with a view on the top side 4 of the cooler 3. It is also possible that parts of the sub-module 14a which forms the inlet-side switching unit 2a overlaps with the inlet 6 without that the active area of the switching unit 2a overlaps with the inlet 6. An overlap may be also defined by an overlap of any part of the overall area of the switching unit 2a as defined by the perimeter of the package body.

The outlet-side switching unit 2c does not overlap with the outlet 8. It is also possible that both the inlet-side switching unit 2a and the outlet-side switching unit 2c overlap, wherein the overlap of the inlet-side switching unit 2a with the inlet 6 is larger than the overlap of the outlet-side switching unit 2c with the outlet 8.

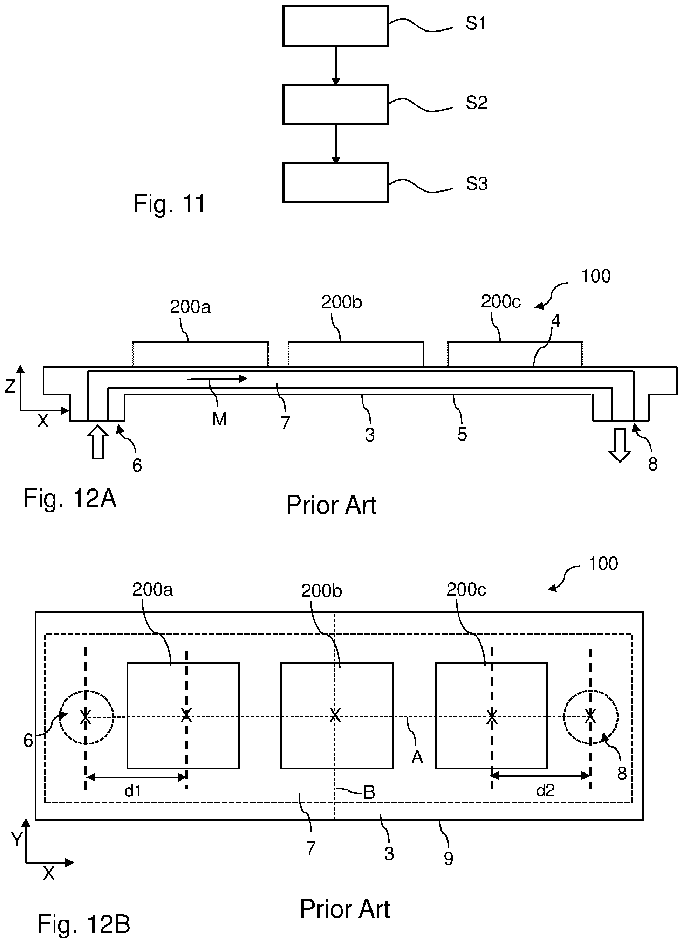

Due to the positioning of the inlet-side switching unit 2a in the vicinity of the inlet 6, the cooling of the inlet-side switching unit 2a is less than without overlap as shown in the comparative example of Figs. 12A and 12B. The switching units 2a, 2b, 2c may be positioned non-symmetrically with respect to a central line B between inlet 6 and outlet 8.

As an example, the positioning as shown in Figs. 1A and 1B may significantly compensate the decrease of heating efficiency due to the temperature increase of the coolant from the position of the inlet-side switching unit 2a towards the position of the outlet-side switching unis 2c. such that the temperature of the active region of the inlet-side switching unit 2a may be the same as the temperature of the active region of the outlet-side switching unit 2c. As an example, in operation, the junction temperature of the further switching unit 2b may be at Tj=x K, while the junction temperatures of the inlet-side switching unit 2a and of the outlet-side switching unit 2c may be at Tj = x+5 K.

Accordingly, the junction temperatures Tj of the switching units 2a, 2b, 2c are more homogenous than for the comparison example. The further switching unit 2b, which is located between the inlet-side switching unit 2a and the outlet-side switching unit 2c, has the lowest junction temperature. In the comparison example, the inlet-side switching unit 2a has the lowest temperature and the outlet-side switching unit 2c has the highest temperature. The overall temperature difference, i.e. the difference between the hottest and coolest one of the switching units 2a, 2b, 2c is smaller than in the comparison example.

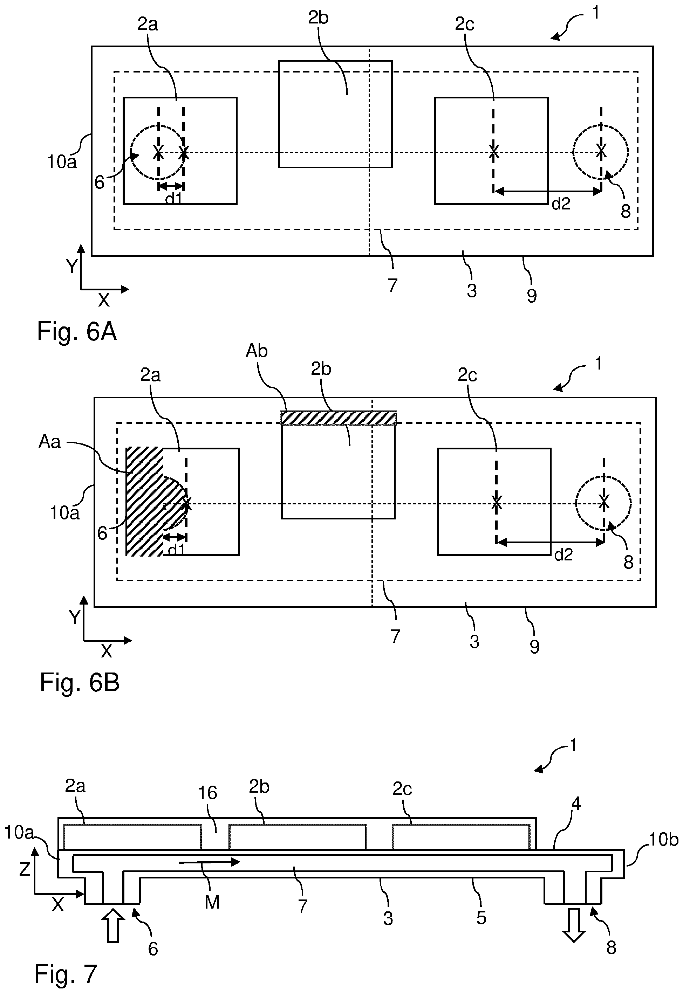

In the shown embodiment, the switching units 2a, 2b, 2c are arranged at regular distances from each other in x-direction. It is also possible that the distances differ in order to further adjust the junction temperatures. Furthermore, in the shown embodiment, the switching units 2a, 2b, 2c are arranged at a straight row along the x-direction. The x-direction may be the direction of a connection line A between inlet 6 and outlet 8. It is also possible that the positions of the switching units 2a, 2b, 2c in y-direction differ from each other to adjust the junction temperatures (see embodiment shown in Fig. 6).

The improved temperature homogeneity of the three switching units 2a, 2b, 2c leads to a more homogenous switching operation between the switching units 2a, 2b, 2c. Further, due to the shown overlap of the inlet-side switching unit 2a with the inlet 6, the extension of the power module 1 in the longitudinal direction is smaller than the extension of the comparative power module 100 shown in Figs. 12A and 12B where all switching units 2a, 2b, 2c are located between inlet 6 and outlet 8. The free space above the inlet 6 does not exist anymore.

Accordingly, the power module 1 consumes less space in applications, leading to a cost advantage. Furthermore, the reduced size of the cooler and consequently lower weight leads to a cost reduction.

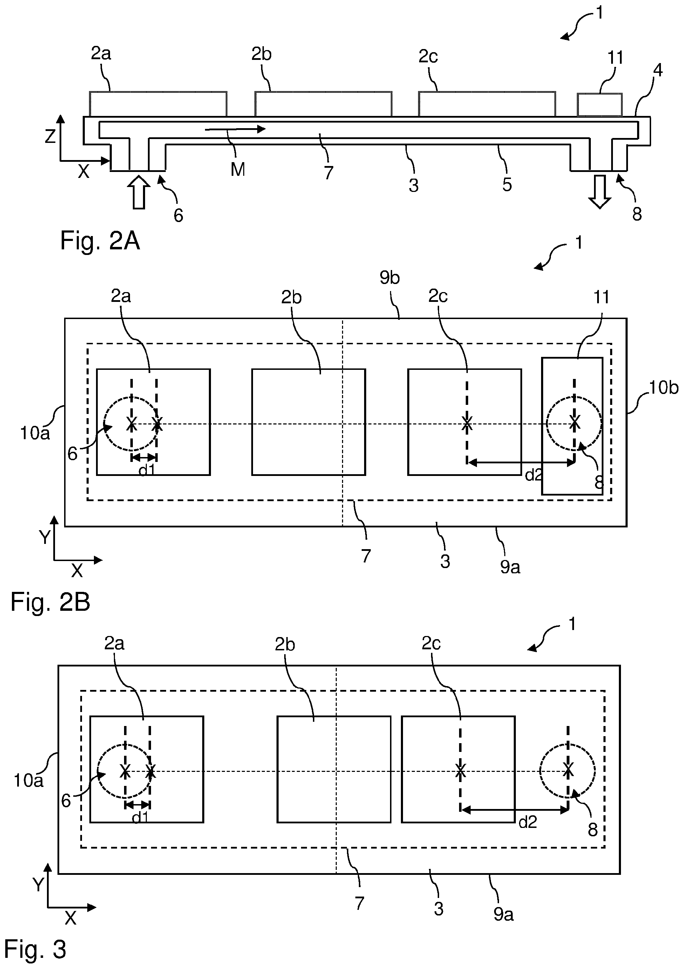

Figs. 2A and 2B show a further embodiment of a power module 1. Compared to the embodiment of Figs. 1A and 1B, a further component 11 is located above the outlet 8.

The further component 11 may be a further electronic device such as switching unit but with a different design and/or functionality of the switching units 2a, 2b, 2c. As an example, the further component 11 may have a different footprint. In this case, the available space both above the inlet 6 and the outlet 8 is used. Such a further component 11 may be added also to the other embodiments. All other features and variations may be as described for the other embodiments. In particular, the amount of overlap of the switching units 2a, 2b, 2c with directed coolant flow is the same as for the embodiment of Figs 1A to 1C.

Fig. 3 shows a further embodiment of a power module 1. Compared to the embodiment of Figs. 1A and 1B, the switching units 2a, 2b, 2c are not positioned at regular distances from each other. The further switching unit 2b is positioned closer to the outlet-side switching unit 2c.

This serves to adjust the junction temperatures of the further switching unit 2b and the outlet-side switching unit 2c, as the flow and temperature of the coolant at the shifted position of the further switching unit 2b may be more homogenous than at the position of the further switching unit 2b of Figs. 1A to 1C. All other features and variations may be as described for the other embodiments. The amount of overlap of the switching units 2a, 2b, 2c with directed coolant flow is the same as for the embodiment of Figs 1A to 1C.

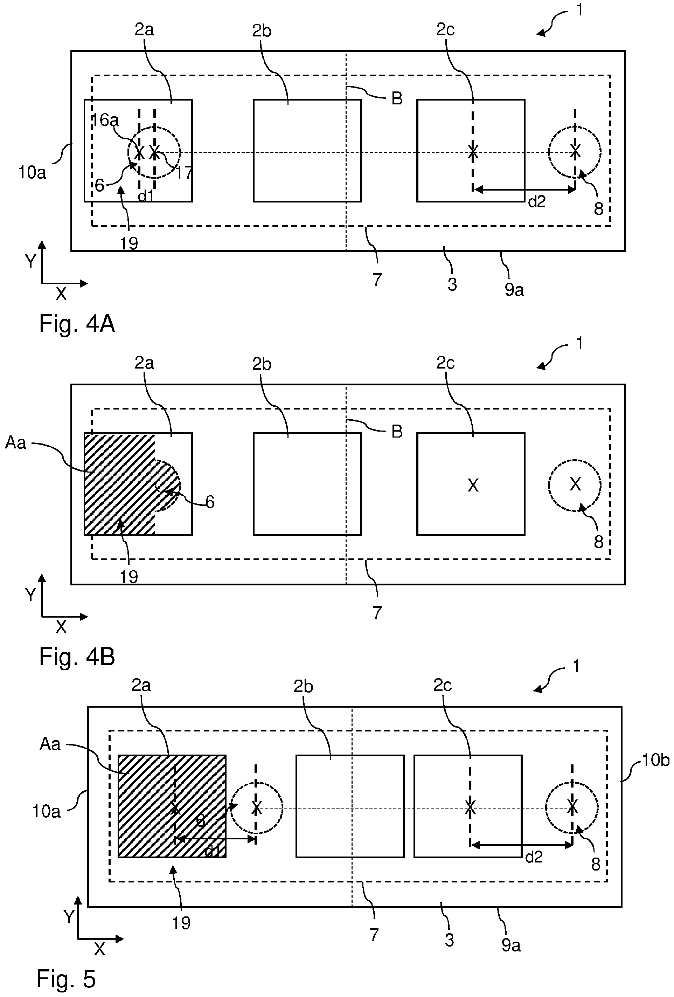

Fig. 4A shows a further embodiment of a power module 1. Compared to the embodiment of Figs. 1A and 1B, the inlet-side switching unit 2a is positioned such that its center point 16a is located between the center point 17 of the inlet 6 and the closest second edge 10a. In this case, although not shown here, the absolute distance between the inlet-side switching unit 2a and the inlet 6 may be larger than the absolute distance between the outlet-side switching unit 2c and the outlet 8.

The inlet-side switching unit 2a has a large overlap with a blind channel section 19 of the cooling channel 7 between the center point of the inlet 6 and the closest second edge 10a. In such a niche or blind channel section 19, the coolant flow in the main flow direction M is low or even almost zero as the blind channel section 19 is a dead end for the coolant, leading to a low cooling efficiency.

The inlet-side switching unit 2a does not even fully overlap with the cooling channel 7 but extends beyond the blind channel section 19 in a direction towards the second edge 10a. Therefore, the amount of directed coolant flow below the switching unit 2a is further reduced as compared to Figs. 1A and 1B and the junction temperature is lowered. All other features and variations may be as described for the other embodiments.

Fig. 4B shows the total overlap Aa of the inlet-side switching unit 2a with the inlet 6, the blind channel section 19 and the area with no overlap with the flow channel 7. The overlap Ab, Ac of the other switching units 2b, 2c with the inlet 6 or outlet 8, a blind channel section 19 and an area not on a flow channel section is zero.

Fig. 5 shows a further embodiment of a power module 1. Compared to the embodiment of Figs. 1A and 1B, the inlet 6 is shifted in a direction towards the outlet 8. The inlet 6 has a larger distance from the adjacent second edge 10a than the outlet 8 from its adjacent second edge 10b. Accordingly, inlet 6 and outlet 8 are positioned not mirror-symmetrically with respect to the central line B.

Further, the inlet-side switching unit 2a is positioned entirely between the inlet 6 and the closest second edge 10a. The inlet-side switching unit 2a entirely overlaps with the blind channel section 19 and does not overlap with a part of the cooling channel 7 which is located in the main flow direction M when seen from the inlet 6. Accordingly, the overlap Aa is the entire area of the inlet-side switching unit 2a. The overlap for the other switching units 2b, 2c is again zero as in the foregoing embodiments. Cooling efficiency is thus, further reduced as the flow channel 7 at this location has less or even no directed coolant flow. All other features and variations may be as described for the other embodiments.

Fig. 6A shows a further embodiment of a power module 1. Compared to the embodiment of Figs. 1A and 1B, the further switching unit 2b is shifted in y-direction. The further switching unit 2b only partially overlaps with the flow channel 7 and consequently only partially overlaps with an area of direct current flow.

Thereby, the total amount of directed coolant flow below the further switching unit 2b is reduced when compared to the previous embodiments and the junction temperature of the further switching unit 2b is increased compared to the embodiment of Figs. 1A and 1B. The junction temperature of the further switching unit 2b is thereby further adjusted to the junction temperatures of the inlet-side switching unit 2a and the outlet-side switching unit 2c.

Fig. 6B shows the total overlap Aa of the inlet-side switching unit 2b and the total overlap Ab of the further switching unit 2b with areas of reduced or no coolant flow.

As an example, during operation, the junction temperature of the further switching unit 2b may be at Tj = x+3 K instead of Tj= x K and the junction temperatures of the inlet-side switching unit 2a and the outlet-side switching unit 2c may be at Tj = x+5 K. All other features and variations may be as described for the other embodiments.

Fig. 7 shows a further embodiment of a power module 1. Compared to the embodiment of Figs. 1A to 1C, the switching units 2a, 2b, 2c are provided as a single sub-module 12. The switching units 2a, 2b, 2c comprise a common package body 16. The switching units 2a, 2b, 2c are placed at regular distance towards each other.

The single sub-module 12 is placed asymmetrically on the cooler 3 so that also in this case the distance of the inlet-side switching unit 2a to the inlet 6 is smaller than the distance of the outlet-side switching unit 2c to the outlet 8 in a top view on the cooler 3.

It is also possible that the inlet-side switching unit 2a and the outlet-side switching unit 2c are placed asymmetrically in the single sub-module 12. In this case, the sub-module may be placed symmetrically on the cooler 3 with the same distances to the second edges 10a, 10b. All other features and variations may be as described for the other embodiments.

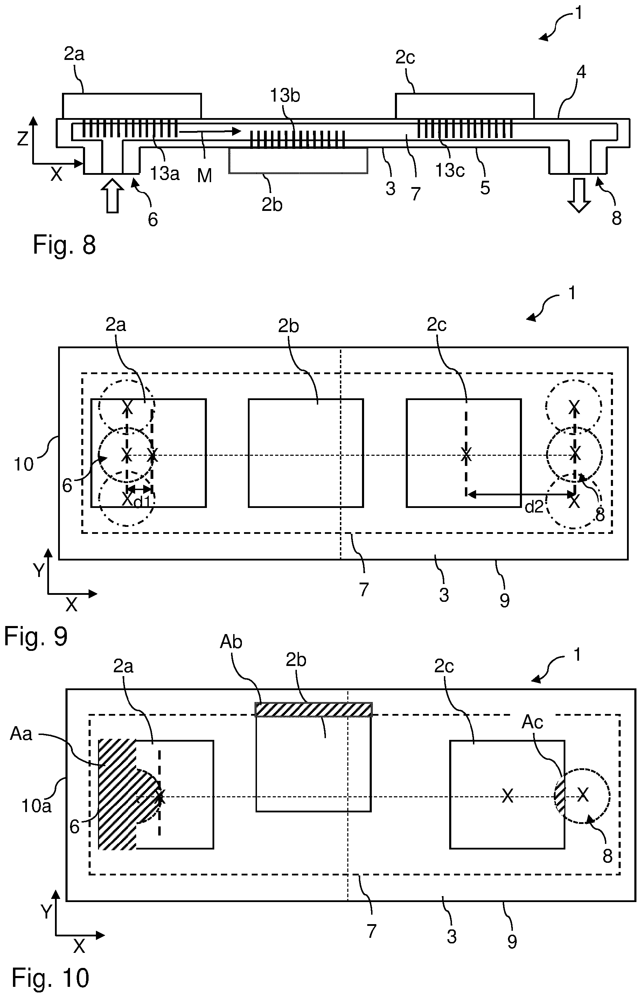

Fig. 8 shows a further embodiment of a power module 1. Compared to the embodiment of Figs. 1A and 1B, the switching units 2a, 2b, 2c comprise pin-fin bottom sides 13a, 13b, 13c reaching into the channel 7 through openings at its top side and bottom side to get in thermal contact with the coolant.

Further, the further switching unit 2b is located on the bottom side 5 of the cooler 3. All other features and variations may be as described for the other embodiments. Also in the embodiments where the switching units 2a, 2b, 2c have a plain bottom surface, one or more of the switching units 2a, 2b, 2c may be mounted on the bottom side 5 of the cooler 3. The bottom side 5 is the side of the cooler 3 that is mounting side of the power module 1 in the application. In this case, space can be saved by an overlap of switching units 2a, 2b, 2c located on different sides of the cooler 3, when seen in a view on the top of the cooler 3.

Fig. 9 shows further embodiments of a power module 1. Compared to the embodiment of Figs. 1A to 1C, the inlet 6 and/or outlet 8 may be shifted in y-direction. Only the inlet 6 may be shifted in y-direction or only the outlet 8 may be shifted in y-direction. It is also possible that both the inlet 6 and the outlet 8 are shifted in y-direction, either with the same shift or a different shift.

However, also in this case the main flow direction M is still in x-direction. Thus, the relevant distances in regard of cooling efficiency are the distance d1 of the inlet-side switching unit 2a from the inlet 6 in x-direction and the distance d2 of the outlet-side switching unit 2c from the outlet 8 in x-direction, also when inlet 6 and/or outlet 8 do not have the same y-position as the switching units 2a, 2b, 2c.

Fig. 10 shows a further embodiment of a power module 1. Compared to the embodiment of Figs. 6A and 6B, there is a slight overlap Ac of the outlet-side switching unit 2c with the outlet **8.** Also in this case, the overlap Aa of the inlet-side switching unit 2a is larger than the overlap Ab of the further switching unit 2b and the overlap Ac of the outlet-side switching unit 2c.

Generally, the amount of directed flow of coolant in the main flow direction from inlet 6 to outlet 8 corresponds to an amount of flow rate and/or pressure drop in the coolant. When the coolant stagnates, e.g. above the inlet 6 and a blind channel section 19, the pressure in the coolant remains constant or at least the pressure drop is much less than in a central section of the cooling channel 7 where the directed flow is large.

Fig. 11 shows steps in a method of manufacturing a power module. The power module may be the one as described in any of the foregoing embodiments.

In a first step S1, a cooler and several switching units are provided. The cooler and switching units are provided in reality or in a computer simulation. The cooler comprises an inlet and an outlet located at a bottom side of the cooler.

The method comprises the further step S2 of determining an amount of directed coolant flow in a main flow direction at different locations in the cooling channel of the cooler. Alternatively or additionally an amount of pressure drop and/or a flow rate at different locations may be determined. The values may be determined during operation.

In particular, the locations can be locations at a top side of the cooler and/or a bottom side suitable for mounting the switching units. The location may be locations with at least a partial overlap with the flow channel. In particular, an amount of directed coolant flow, the pressure drop and/or the flow rate in vicinity of the inlet may be determined.

In a further step S3, the switching units are mounted such on the cooler that in a view on a top side of the cooler, the inlet-side switching unit, which is closest to the inlet, is mounted on a location where the amount of directed coolant flow, the flow rate and/or the pressure drop is smaller than at a position of at least another one of the switching units. In particular, the overlap of the inlet-side switching unit with the inlet and/or a blind channel section of the cooling channel and/or an area of the cooler where the cooling channel is not present in a top view on the cooler is larger than for another one of the switching units.

Thereby, the lower temperature of the coolant at the location of the inlet-side switching unit can be at least partially compensated by a reduced overlap with directed coolant flow. Figs. 12A and 12B show an illustrative comparison example of a power module 100 not in accordance with the present invention.

Three switching units 200a, 200b, 200c are positioned in a row on top of the cooling channel 8. The distance d1 of the inlet-side switching unit 2a from the inlet 6 is the same as the distance d2 of the outlet side switching unit 2c from the outlet 8. At these locations, the same, homogenous flow rate of the coolant is present. The switching units 200a, 200b, 200c are arranged mirror-symmetrically in x- and y-direction. The inlet-side switching unit 200a has the same distance from the inlet 6 as the outlet-side switching unit 200c from the outlet 8. The inlet 6 and outlet 8 are not directly positioned below any of the switching units 2a, 2b, 2c. The space above inlet 6 and outlet 8 is unused.

Due to the increase of the temperature of the coolant in the flow channel 7 from the inlet 6 towards the outlet 8, the cooling efficiency of the coolant decreases along the flow-channel 7. Therefore, in operation, the inlet-side switching unit 2a has the lowest junction temperature Tj (e.g. Tj = x-5 K), the further switching unit 2b has a higher junction temperature (e.g. Tj = x K) and the outlet-side switching unit 2c has the highest junction temperature (e.g. Tj = x+5 K) due to the temperature increase of the coolant. Accordingly, the junction temperatures Tj of the switching units 2a, 2b, 2c increase in a direction from the inlet 6 towards the outlet 8. The overall temperature difference is 10 K.

### Reference Signs

1 power module
2a inlet-side switching unit
2b further switching unit
2c outlet-side switching unit
3 cooler
4 top side
5 bottom side
6 inlet
7 cooling channel
8 outlet
9a, 9b first edges
10a, 10b second edges
11 further component
12 single sub-module
13a, 13b, 13c pin-fin bottom sides
14a, 14b, 14c separate sub-modules
15 switching device
16a, 16b, 16c center points of switching units
17 center point of inlet
18 center point of outlet
19 blind channel section
100 power module (comparative example)
200a, 200b, 200c switching units (comparative example)
d1 distance
d2 distance
x x-direction
y y-direction
A connection line between inlet and outlet
B central line
M main flow direction
Aa, Ab, Ac overlap

## Claims

1. A power module (1)
comprising several switching units (2a, 2b, 2c) and a cooler (3) for liquid cooling, wherein the switching units (2a, 2b, 2c) are mounted on the cooler (3),
wherein the cooler (3) comprises an inlet (6) and an outlet (8) for a cooling liquid, the inlet (6) and the outlet (8) being located on a top side (4) and/or a bottom side (5) of the cooler (3),
wherein in a view on the top side (4) of the cooler (3) an overlap (Aa, Ab, Ac) of one of the switching units (2a, 2b, 2c) with the inlet (6), the outlet (8), a blind channel section (19) of the cooling channel (7) and/or an area of the cooler (3) where the cooling channel (7) is not present is larger than for another one of the switching units (2a, 2b, 2c).

2. The power module of claim 1,
wherein the switching units (2a, 2b, 2c) comprise an inlet-side switching unit (2a) and an outlet-side switching unit (2c), wherein in a view on the top side (4) of the cooler (3) the inlet-side switching unit (2a) is closest to the inlet (6) and the outlet-side switching unit is closest to the outlet (8), wherein the overlap (Aa, Ab, Ac) is larger for the inlet-side switching unit (2a) than for the outlet-side switching unit (2c).

3. The power module (1) of claim 2,
wherein the inlet-side switching unit (2a) overlaps at least partly with the inlet (6), wherein the outlet-side switching unit (2c) does not overlap with the outlet (8) or overlaps with the outlet (5) to a smaller extent than the inlet-side switching unit (2a) with the inlet (6).

4. The power module of any of claims 2 and 3,
wherein in a view on a top side (4) of the cooler (3), the cooler (3) has first edges (9a, 9b) opposite to each other and second edges (10a, 10b) opposite to each other, wherein the first edges (9a, 9b) define an x-direction and the second edges (10a, 10b) define an y-direction,
wherein, when seen in a view on the top side (4) of the cooler (3), a distance (d1) in x-direction of the inlet-side switching unit (2a) from the inlet (6) is smaller than a distance (d2) in x-direction of the outlet-side switching unit (2c) from the outlet (8).

5. The power module (1) of any of the preceding claims, wherein the switching units (2a, 2b, 2c) are arranged in a straight row or a non-straight row.

6. The power module (1) of any of the preceding claims, wherein the switching units (2a, 2b, 2c) are phase-leg switching units.

7. The power module (1) of any of the preceding claims, wherein the switching units (2a, 2b, 2c) are provided as separate sub-modules (14a, 14b, 14c).

8. The power module (1) of any of claims 1 to 6,
wherein the switching units (2a, 2b, 2c) are provided in a single sub-module (12).

9. The power module (1) of any of the preceding claims, configured such that in a view on the top side (4) of the cooler (3) the at least one of the switching units (2a, 2b, 2c) is located at a position where the amount of directed coolant flow, the flow rate and/or the pressure drop in the cooling channel (7) is smaller than at a position of the another one of the switching units (2a, 2b, 2c).

10. The power module (1) of any of the preceding claims, wherein the inlet (6) is located at a larger distance from its adjacent edge (10a) of the cooler (3) than the outlet (8) from its adjacent edge (10b) of the cooler (3).

11. The power module (1) of any of the preceding claims, comprising a further switching unit (2b) located between the inlet-side switching unit (2a) and the outlet-side switching unit (2c), wherein the switching units (2a, 2b, 2c) are located at equal distances to each other.

12. The power module (1) of any of the preceding claims, wherein the further switching unit (2b) is located at a larger distance from the inlet-side switching unit (2a) than from the outlet-side switching unit (2c).

13. The power module (1) of any of the preceding claims, wherein the switching units (2a, 2b, 2c) are positioned such that, in operation, the junction temperature of the inlet-side switching unit (2a) is higher than the junction temperature of at least another one of the switching units (2a, 2b, 2c).

14. The power module (1) of any of the preceding claims, comprising a further component (11), wherein in a view on the top side (4), the further component (11) overlaps with the outlet (8) or is located on a blind channel section (19) of the cooling channel (7).

15. A method for manufacturing a power module (1), comprising the steps of:
providing a cooler (3) and several switching units (2a, 2b, 2c), wherein the cooler (3) comprises an inlet (6) and an outlet (8) for a cooling liquid, the inlet (6) and the outlet (8) being located on a top side (4) and/or bottom side (5) of the cooler (3),
determining the amount of directed coolant flow along a main flow direction (M), a pressure drop and/or a flow rate at different locations of the cooler (3) and mounting the switching units (2a, 2b, 2c) such on the cooler (3) that an amount of directed coolant flow, a flow rate and/or a pressure drop at a position of one of the switching units (2a, 2b, 2c) is smaller than at a position of at least another one of the switching units (2a, 2b, 2c).
